# EUROPEAN PATENT APPLICATION

(11) **EP 4 797 000 A1**
(43) Date of publication of application: **26.08.2026**
(21) Application number: 24923920.3
(22) Date of filing: 08.02.2024
(51) Int. Cl.: G03F 7/023

(54) **POSITIVE PHOTOSENSITIVE RESIN COMPOSITION, INSULATING RESIN FILM, METHOD FOR FORMING INSULATING RESIN FILM, AND SEMICONDUCTOR DEVICE**

(71) Applicant: Resonac Corporation, Tokyo 105-7325 (JP)
(72) Inventor: AOKI Yukika, Tokyo 105-7325 (JP); ARAI Yoshikazu, Tokyo 105-7325 (JP); AOKI Yu, Tokyo 105-7325 (JP)
(74) Representative: Berggren Oy
(86) International application number: PCT/JP2024/004405
(87) International publication number: WO 2025/169420

(57) **Abstract**

A positive-type photosensitive resin composition containing:
(A) an alkali-soluble resin; (B) a photoacid generator that is a compound generating an acid by light; and (C) a thermal crosslinking agent that is a compound crosslinking the alkali-soluble resin by heat. The alkali-soluble resin contains a constitutional unit that is a group obtained by removing one or more hydrogen atoms from a bisphenol imide compound represented by the following Formula (I). 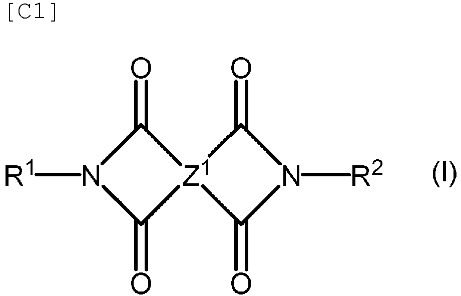 R¹ and R² are each independently a hydroxyphenyl group represented by the following Formula (1a) or (1b).

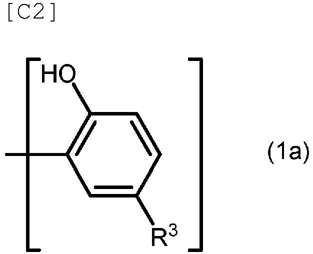

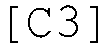

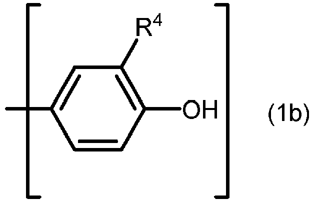

## Description

### Technical Field

The present disclosure relates to a positive-type photosensitive resin composition, an insulating resin film having a pattern that includes an aperture, a method for forming an insulating resin film having a pattern that includes an aperture, and a semiconductor device.

### Background Art

PTL 1 discloses a positive-type photosensitive resin composition that contains an alkali-soluble resin having an imide bond and a phenolic hydroxyl group as a material capable of affording a surface protective layer or an interlayer insulating layer of a semiconductor element.

### Citation List

### Patent Literature

[PTL 1] WO 2021/261448

### Summary of Invention

### Technical Problem

The present disclosure relates to a positive-type photosensitive resin composition capable of affording an insulating resin film, which exhibits a large elongation at break as well as has a surface exhibiting little tack immediately after development.

### Solution to Problem

The present disclosure includes the following:
[1] A positive-type photosensitive resin composition containing:
   (A) an alkali-soluble resin;
   (B) a photoacid generator that is a compound generating an acid by light; and
   (C) a thermal crosslinking agent that is a compound crosslinking the alkali-soluble resin by heat,

   in which the alkali-soluble resin contains a constitutional unit that is a group obtained by removing one or more hydrogen atoms from a bisphenol imide compound represented by the following Formula (I): 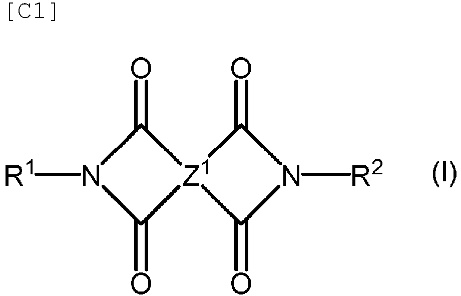
   wherein Z¹ is a tetravalent organic group, R¹ and R² are each independently a hydroxyphenyl group represented by the following Formula (1a) or (1b): 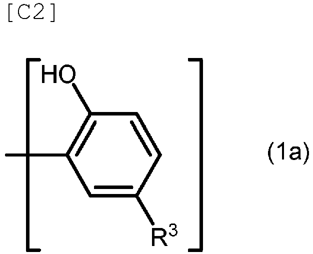 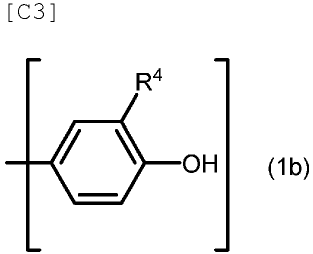
   wherein R³ and R⁴ are each independently an alkyl group having 1 to 3 carbon atoms.
[2] The positive-type photosensitive resin composition according to [1], in which the bisphenol imide compound is a compound represented by the following Formula (I'): 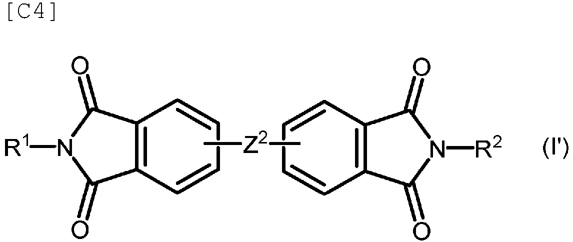 wherein R¹ and R² are synonymous with R¹ and R² in Formula (I), and Z² is a divalent organic group or a covalent bond.
[3] The positive-type photosensitive resin composition according to [1] or [2], in which the alkali-soluble resin includes a novolac resin which is a product of a reaction of phenol compounds including the bisphenol imide compound with one or more reactive compounds selected from an aldehyde compound, a compound having a plurality of methoxymethyl groups, or a compound having a plurality of hydroxymethyl groups.
[4] The positive-type photosensitive resin composition according to [3], in which a proportion of the bisphenol imide compound is 10 mol% or more and 100 mol% or less based on a total amount of the phenol compounds.
[5] The positive-type photosensitive resin composition according to any of [1] to [4], in which the thermal crosslinking agent contains an alkoxy compound having a plurality of alkoxy groups.
[6] A method for forming an insulating resin film, the method including:
   exposing a part of a photosensitive layer containing the positive-type photosensitive resin composition according to any of [1] to [5];
   forming an insulating resin film having a pattern that includes an aperture by development for removing a part of the photosensitive layer; and
   heating the insulating resin film.
[7] An insulating resin film including a cured product of the positive-type photosensitive resin composition according to any of [1] to [5] and having a pattern that includes an aperture.
[8] A semiconductor device including:
   a semiconductor chip; and
   a wiring portion that includes a conductor wiring layer connected to the semiconductor chip and one or more insulating layers,
   in which at least some of the one or more insulating layers are the insulating resin film according to [7].

### Advantageous Effects of Invention

The positive-type photosensitive resin composition according to the present disclosure can afford an insulating resin film, which exhibits a large elongation at break as well as has a surface exhibiting little tack immediately after development. Little tack or substantially no tack can be advantageous for efficient formation of a rewiring layer including, for example, an insulating resin film.

### Brief Description of Drawings

[Fig. 1]

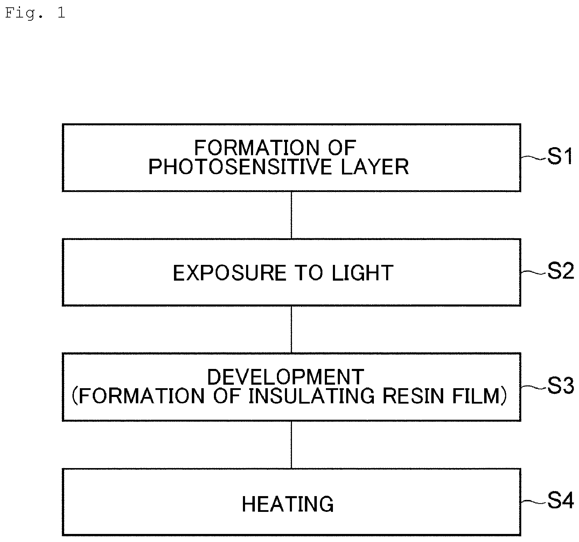

   Fig. 1 is a flowchart illustrating an example of a method for forming an insulating resin film having a pattern.
[Fig. 2]

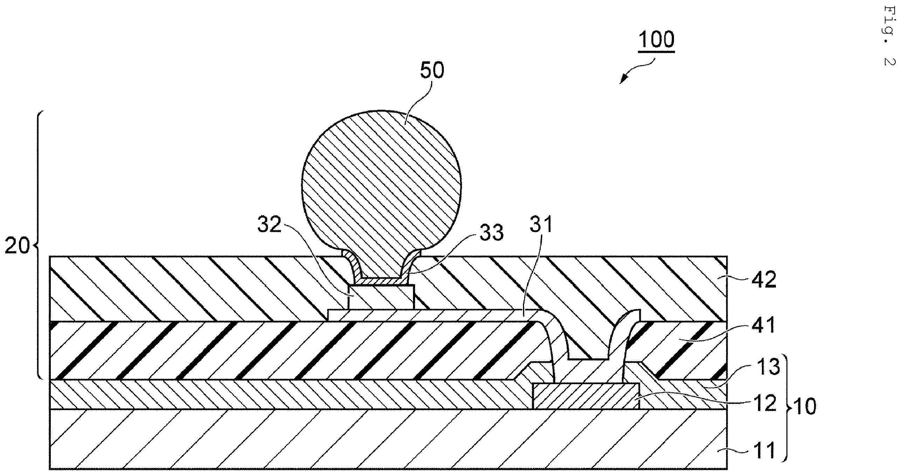

   Fig. 2 is a partial cross-sectional view illustrating an example of a semiconductor device.

### Description of Embodiments

The present invention is not limited to the following examples. In the present disclosure, the term "step" includes not only independent steps, but also steps that are not clearly distinguishable from other steps as long as the intended action of the step is achieved. The term "layer", when observed as a plan view, includes not only a structure having a shape formed on the entire surface but also a structure having a shape formed on a part of the entire surface. A numerical range indicated using "to" indicates a range that includes the numerical values before and after "to" as the minimum and maximum values, respectively. In the numerical ranges stated in stages in the present specification, the upper limit value or lower limit value of the numerical range in a certain stage may be replaced with the upper limit value or lower limit value of the numerical range in another stage. In a numerical range described in the present specification, the upper limit value or lower limit value of the numerical range may be replaced with the value presented in Examples.

### Photosensitive resin composition

An example of the photosensitive resin composition contains (A) an alkali-soluble resin, (B) a photoacid generator that is a compound generating an acid by light, and (C) a thermal crosslinking agent that is a compound crosslinking the alkali-soluble resin by heat. The photosensitive resin composition according to the present disclosure can function as a positive-type photosensitive resin composition based on the change in solubility into an alkali developing solution due to exposure to light. Moreover, a film containing the photosensitive resin composition according to the present disclosure can be thermally cured mainly by a crosslinking reaction of the thermal crosslinking agent with the alkali-soluble resin and afford an insulating resin film, which is a cured film containing a cured product of the photosensitive resin composition.

### (A) Alkali-soluble resin

In the present disclosure, an alkali-soluble resin means a resin that dissolves in an aqueous solution of tetramethylammonium hydroxide (TMAH) having a concentration of 2.38% by mass at 25°C. Whether a resin is alkali-soluble is examined by a method that includes forming a resin film of the resin having a thickness of about 1 µm on a substrate and immersing the resin film in an aqueous solution of TMAH having a concentration of 2.38% by mass at 25°C. For example, the resin is regarded as an alkali-soluble resin in a case where the resin film completely dissolves in the aqueous solution of TMAH in an immersion time of 60 minutes or less in a state in which the aqueous solution of TMAH is left to still stand.

The alkali-soluble resin of the component (A) is a resin or polymer containing a constitutional unit that is a group obtained by removing one or more hydrogen atoms from a bisphenol imide compound represented by the following Formula (I). The alkali-soluble resin may be a novolac resin containing a constitutional unit derived from a bisphenol imide compound represented by Formula (I).

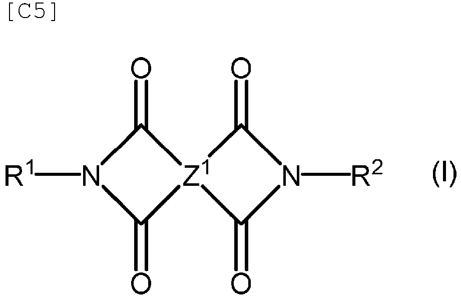

In Formula (I), Z¹ is a tetravalent organic group, R¹ and R² are each independently a hydroxyphenyl group represented by the following Formula (1a) or (1b). R³ in Formula (1a) and R⁴ in Formula (1b) are each independently an alkyl group having 1 to 3 carbon atoms (for example, a methyl group).

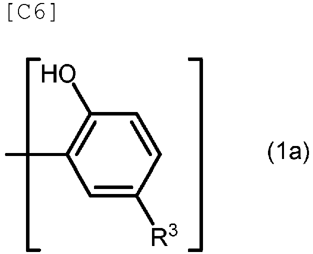

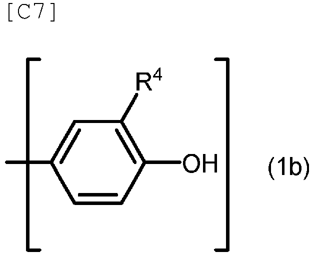

The hydroxyphenyl group represented by Formula (1a) or (1b) has one phenolic hydroxyl group, and the number of hydrogen atoms bonded at the ortho-position or para-position with respect to the phenolic hydroxyl group is one. Generally, in a hydroxyphenyl group, the hydrogen atom bonded at the ortho-position or para-position with respect to the phenolic hydroxyl group tends to be easily substituted with a reactive compound such as an aldehyde compound. The bisphenol imide compound represented by Formula (I) has a hydroxyphenyl group represented by Formula (1a) or (1b) and has two hydrogen atoms at positions where substitution easily takes place. In this way, when the number of hydrogen atoms at positions where substitution easily takes place is small, it is considered that the polymer is unlikely to have an excessively crosslinked structure and this contributes to the improvement in elongation at break of an insulating resin film. Furthermore, the hydroxyphenyl group represented by Formula (1a) or (1b) also contributes to a decrease in tack of the surface of an insulating resin film.

The constitutional unit derived from a bisphenol compound represented by Formula (I) can be, for example, a divalent group represented by the following Formula (IA), (IB), or (IC). Z¹, R³, and R⁴ in Formulas (IA) to (IC) are synonymous with Z¹, R³, and R⁴ in Formula (I), (1a) or (1b).

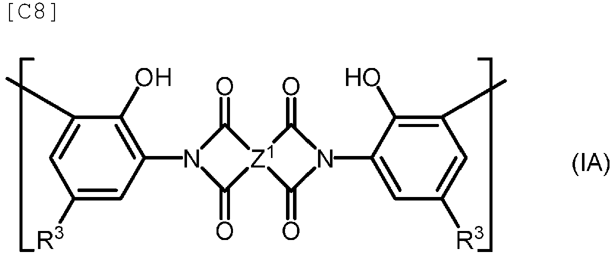

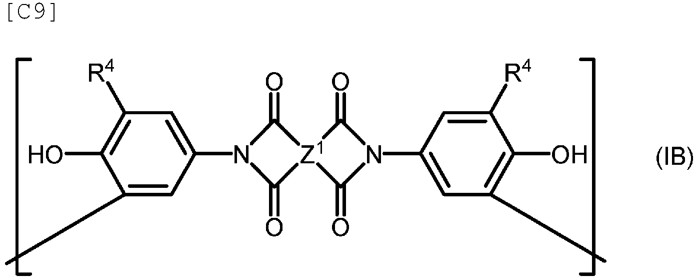

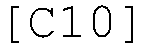

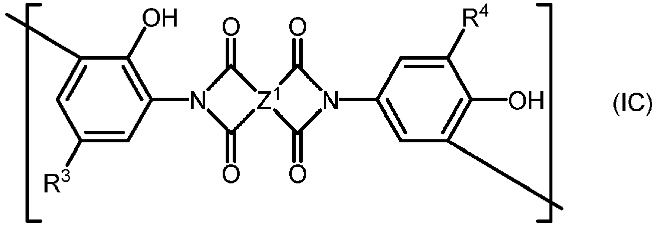

Z¹ in Formula (I) may be one cyclic hydrocarbon group which may have a substituent (for example, an alkyl group having 1 to 3 carbon atoms) or a group having two or more cyclic hydrocarbon groups which may have a substituent (for example, an alkyl group having 1 to 3 carbon atoms) and a divalent organic group or covalent bond that bonds these.

Examples of the cyclic hydrocarbon group in Z¹ include groups obtained by removing one or more hydrogen atoms from the following cyclic hydrocarbon compounds.

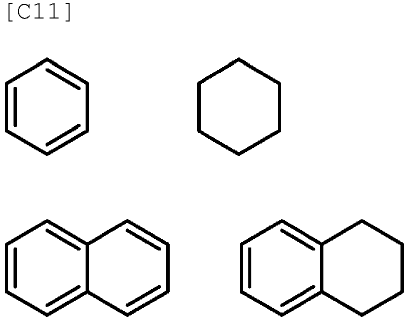

The divalent organic group that bonds two cyclic hydrocarbon groups in Z¹ may be a divalent group selected from, for example, an oxy group (-O-), a thio group (-S-), a carbonyl group, an alkylene group having 1 to 3 carbon atoms, a phenylene group, an alkylphenylene group, and a group consisting of a combination thereof. Examples of the alkylene group having 1 to 3 carbon atoms include a methylene group, an ethylene group, an ethylidene group, a propane-1,3-diyl group, a propane-1,1-diyl group, and a propane-2,2-diyl group. Specific examples of the divalent organic group that bonds two cyclic hydrocarbon groups in Z¹ include the following in addition to an alkylene group having 1 to 3 carbon atoms.

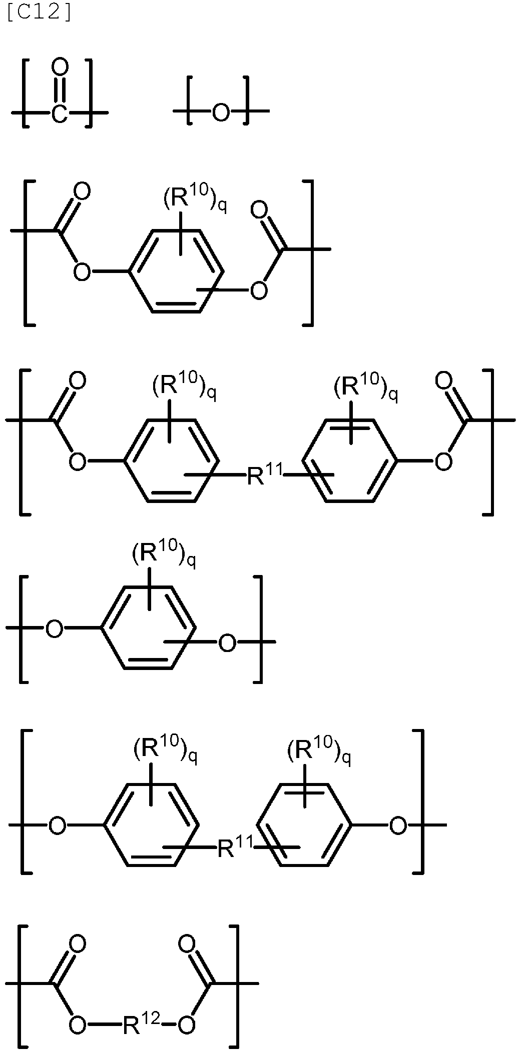

In these formulas, R¹⁰ represents an alkyl group having 1 to 3 carbon atoms (for example, a methyl group), and a plurality of R¹⁰'s in the same molecule may be the same or different. q represents an integer from 0 to 4, a plurality of q's in one formula may be the same or different. R¹¹ represents an alkylene group (for example, a propane-2,2-diyl group or a methylene group), an oxy group, a thio group, or a covalent bond. R¹² represents an alkylene group (for example, an ethane-1,2-diyl group).

The bisphenol imide compound represented by Formula (I) may be a compound represented by the following Formula (I'). R¹ and R² in Formula (I') are synonymous with R¹ and R² in Formula (I). Z² is a divalent organic group or a covalent bond.

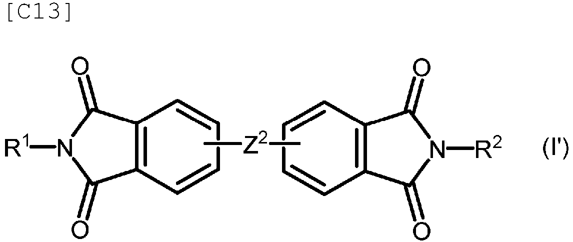

Examples of the divalent organic group as Z² in Formula (I') include those similar to the examples of the divalent organic group that bonds two cyclic hydrocarbon groups in Z¹. When Z² is a covalent bond, an insulating resin film that is particularly excellent in PCT resistance is likely to be formed. When Z² is an oxy group, an insulating resin film that exhibits particularly a large elongation at break and a large breaking strength is likely to be formed.

The alkali-soluble resin may be a novolac resin that is a product of the reaction of a phenol compound including a bisphenol imide compound represented by Formula (I) with one or more reactive compounds selected from an aldehyde compound, a compound having a plurality of methoxymethyl groups, or a compound having a plurality of hydroxymethyl groups. The phenol compounds in this case may further include a compound having a phenolic hydroxyl group other than the bisphenol imide compound, examples of which include phenol and the above-mentioned phenol derivatives.

The aldehyde compound constituting the novolac resin may be formaldehyde. The compound having a plurality of methoxymethyl groups may be a compound having an aromatic ring (for example, a benzene ring) to which a methoxymethyl group is bonded. The compound having a plurality of hydroxymethyl groups may be a compound having an aromatic ring (for example, a benzene ring) to which a hydroxymethyl group is bonded. Examples of the compound having a plurality of methoxymethyl groups include a compound represented by the following Formula (21) or (22). In these formulas, R¹⁰ represents an alkyl group having 1 to 3 carbon atoms (for example, a methyl group). A plurality of R¹⁰'s in the same molecule may be the same or different. p represents an integer from 0 to 4, and q and r each independently represent an integer from 0 to 4. The compound having a plurality of methoxymethyl groups may be bis(methoxymethyl)biphenyl, dimethoxymethyl benzene, or a combination thereof. Examples of the compound having a plurality of hydroxymethyl groups include 2,6-bis(hydroxymethyl)-p-cresol.

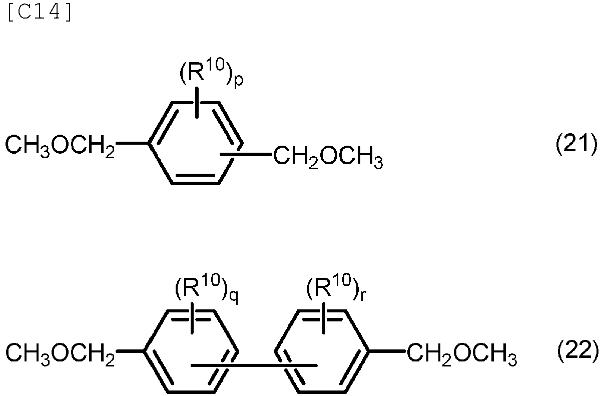

The residue derived from formaldehyde is usually a methylene group. The residue derived from a compound having two or more methoxymethyl groups can be, for example, a divalent group represented by the following Formula (21A) or (22A). R¹⁰, p, q, and r in Formulas (21A) and (22A) are synonymous with R¹⁰, p, q, and r in Formulas (21) and (22).

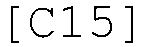

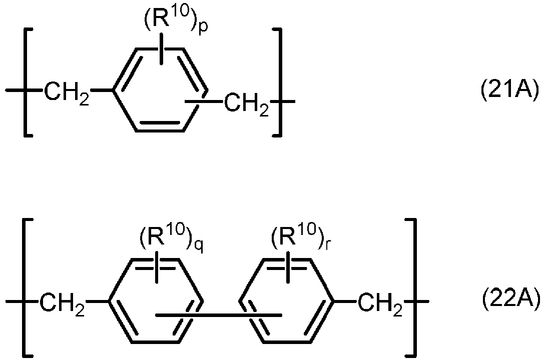

In the phenol compound that reacts with an aldehyde compound or the like in the reaction for producing the novolac resin, the proportion of the bisphenol imide compound may be 10 mol% or more and 100 mol% or less, 20 mol% or more and 100 mol% or less, 30 mol% or more and 100 mol% or less, or 40 mol% or more and 100 mol% or less based on the total amount of phenol compounds. When the proportion of the bisphenol imide compound is large, particularly excellent effects in terms of elongation at break, heat resistance, and suppression of thermal expansion of the insulating resin film are likely to be obtained. From a similar viewpoint, the proportion of the bisphenol imide compound may be 50 mol% or more, 60 mol% or more, 70 mol% or more, 80 mol% or more, or 90 mol% or more based on the total amount of phenol compounds, and may be substantially 100 mol%.

The novolac resin that is an alkali-soluble resin can be synthesized, for example, by a method conforming to general methods for synthesizing phenol novolac resins or cresol novolac resins.

The weight average molecular weight (Mw) of the alkali-soluble resin may be 1000 to 500000, 2000 to 400000, 3000 to 350000, or 5000 to 300000 from the viewpoint of the balance among solubility in an aqueous alkali solution, photosensitive properties, and mechanical strength of the insulating resin film. In the present disclosure, the weight average molecular weight is a value converted by the standard polystyrene calibration curve measured by gel permeation chromatography (GPC).

The alkali-soluble resin may have a molecular chain derived from an elastomer. Examples of the elastomer will be described later.

### (B) Photoacid generator

The photoacid generator of the component (B) contains one or more compounds that generate an acid by light (for example, ultraviolet light), and functions as a photosensitizer in the photosensitive resin composition. By the action of an acid generated from the photoacid generator by absorption of light, the solubility of the photosensitive layer at the portion irradiated with light into an aqueous alkali solution is selectively increased.

The compound constituting the photoacid generator may be selected from compounds generally used as a photoacid generator. The compound that generates an acid by light may be, for example, an o-quinone diazide compound, an aryldiazonium salt, a diaryliodonium salt, or a triarylsulfonium salt, or a combination of two or more selected from these.

From the viewpoint of the improvement in sensitivity to exposure to light, the photoacid generator may contain an o-quinone diazide compound. An o-quinone diazide compound is a compound having an aromatic group, an oxo group (=O), and a diazide group (=N⁺=N⁻), in which the oxo group and the diazide group are each bonded to adjacent carbon atoms in the aromatic group. The aromatic group may be, for example, a group obtained by removing a hydrogen atom from naphthalene or benzene.

The o-quinone diazide compound may have, as a group containing an oxo group and a diazide group, for example, a group represented by the following Formula (3a), (3b), or (3c).

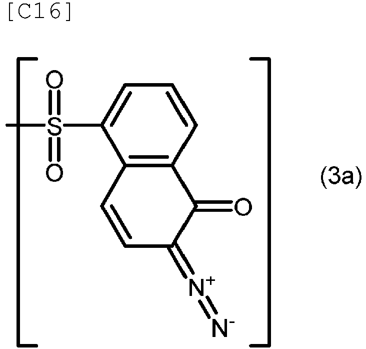

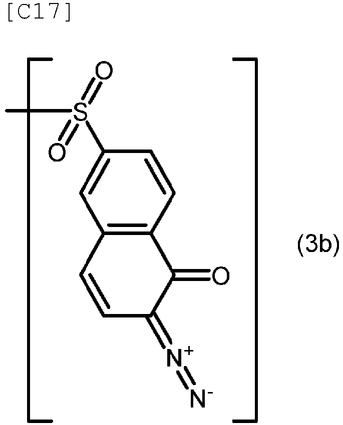

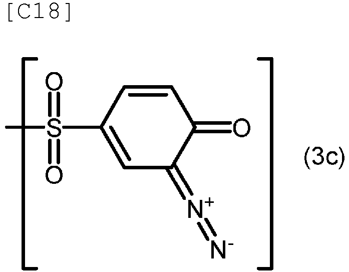

The compound having a group represented by Formula (3a), (3b), or (3c) may be, for example, a product of the condensation reaction of o-quinone diazide sulfonyl chloride with a hydroxy compound and/or an amino compound in the presence of a dehydrochlorinating agent. In this case, the o-quinone diazide compound can be a compound having a residue derived from the hydroxy compound or amino compound and the group represented by Formula (3a), (3b) or (3c). For example, the compound having a group represented by Formula (3a) can be obtained from naphthoquinone-1,2-diazide-5-sulfonyl chloride. The compound having a group represented by Formula (3b) can be obtained from naphthoquinone-1,2-diazide-6-sulfonyl chloride. The compound having a group represented by Formula (3c) can be obtained from benzoquinone-1,2-diazide-4-sulfonyl chloride.

The o-quinone diazide compound may be a compound having a residue derived from a hydroxy compound or an amino compound and a group represented by Formula (3a), (3b), or (3c).

The hydroxy compound that can be used to synthesize the o-quinone diazide compound is a compound having one or more hydroxyl groups. The residue of a hydroxy compound can be a group obtained by removing one or more hydrogen atoms from the hydroxyl group of the hydroxy compound. Examples of the hydroxy compound include hydroquinone, resorcinol, pyrogallol, bisphenol A, bis(4-hydroxyphenyl)methane, 1,1-bis(4-hydroxyphenyl)-1-[4-{1-(4-hydroxyphenyl)-1-methylethyl}phenyl]ethane, 2,2-bis(4-hydroxyphenyl)hexafluoropropane, 2,3,4-trihydroxybenzophenone, 2,3,4,4'-tetrahydroxybenzophenone, 2,2',4,4'-tetrahydroxybenzophenone, 2,3,4,2',3'-pentahydroxybenzophenone, 2,3,4,3',4',5'-hexahydroxybenzophenone, bis(2,3,4-trihydroxyphenyl)methane, bis(2,3,4-trihydroxyphenyl)propane, 4b,5,9b,10-tetrahydro-1,3,6,8-tetrahydroxy-5,10-dimethylindeno[2,1-a]indene, tris(4-hydroxyphenyl)methane, and tris(4-hydroxyphenyl)ethane.

Specific examples of the compound having a residue of a hydroxy compound and a group represented by Formula (3a), (3b), or (3c) include a compound represented by the following Formula (31), (32), (33), (34), (35), or (36). These compounds are likely to absorb light in a proper wavelength range for exposure of the photosensitive layer to light.

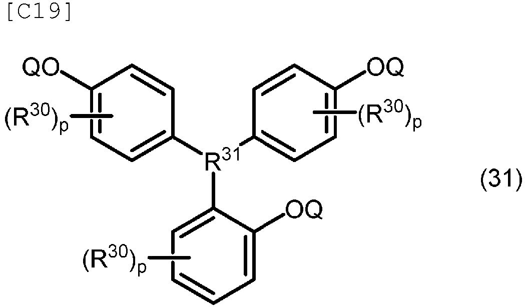

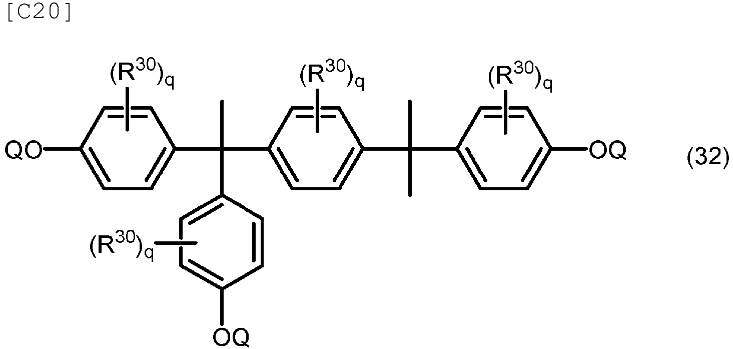

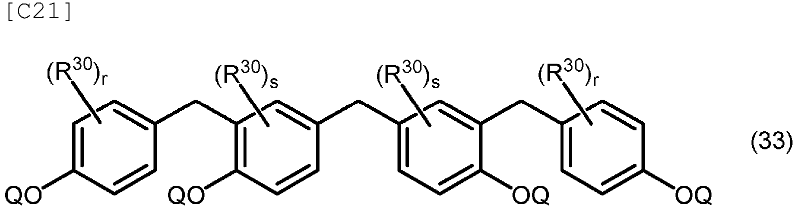

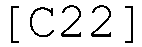

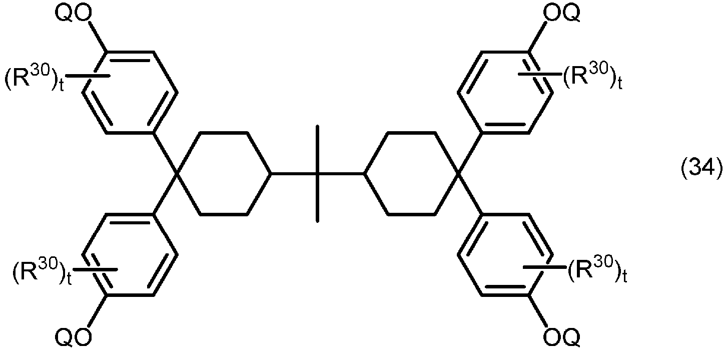

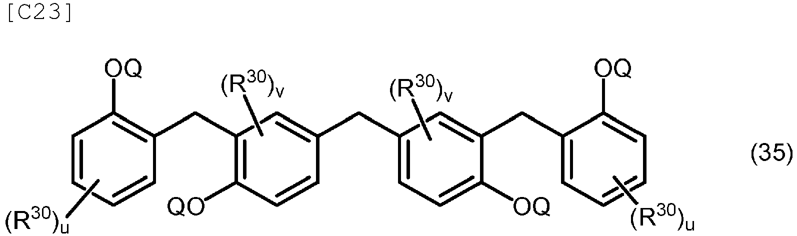

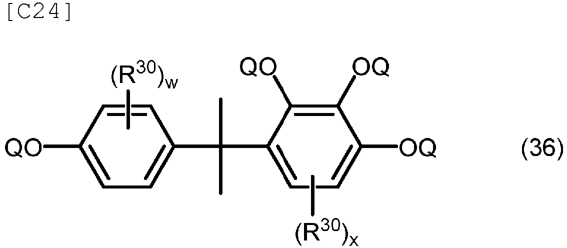

In Formulas (31) to (36), Q represents a group represented by Formula (3a), (3b), or (3c), or a hydrogen atom, and a plurality of Q's in the same molecule may be the same or different, and at least one of the plurality of Q's in the same molecule is a group represented by Formula (3a), (3b), or (3c). In Formulas (31) to (36), R³⁰ represents an alkyl group having 1 to 3 carbon atoms (for example, a methyl group), and a plurality of R³⁰'s in the same molecule may be the same or different. In Formula (31), R³¹ represents an alkanetriyl group having 1 to 3 carbon atoms (for example, a methanetriyl group or an ethane-1,1,1-triyl group), and a plurality of p's each independently represent an integer from 0 to 4. In Formula (32), a plurality of q's each independently represent an integer from 0 to 4. In Formula (33), a plurality of r's each independently represent an integer from 0 to 4, and a plurality of s's each independently represent an integer from 0 to 3. In Formula (34), a plurality of t's each independently represent an integer from 0 to 4. In Formula (35), a plurality of u's each independently represent an integer from 0 to 4, and a plurality of v's each independently represent an integer from 0 to 3. In Formula (36), w represents an integer from 0 to 4, and x represents an integer from 0 to 2.

The amino compound that can be used to synthesize the o-quinone diazide compound is a compound having one or more amino groups. The residue of an amino compound can be a group obtained by removing one or more hydrogen atoms from the amino group of the amino compound. Examples of the amino compound include p-phenylenediamine, m-phenylenediamine, 4,4'-diaminodiphenyl ether, 4,4'-diaminodiphenylmethane, 4,4'-diaminodiphenyl sulfone, 4,4'-diaminodiphenyl sulfide, o-aminophenol, m-aminophenol, p-aminophenol, 3,3'-diamino-4,4'-dihydroxybiphenyl, 4,4'-diamino-3,3'-dihydroxybiphenyl, bis(3-amino-4-hydroxyphenyl)propane, bis(4-amino-3-hydroxyphenyl)propane, bis(3-amino-4-hydroxyphenyl)sulfone, bis(4-amino-3-hydroxyphenyl)sulfone, bis(3-amino-4-hydroxyphenyl)hexafluoropropane, and bis(4-amino-3-hydroxyphenyl)hexafluoropropane.

The content of the photoacid generator may be 1% to 50% by mass, 3% to 35% by mass, or 5% to 20% by mass with respect to the content of the alkali-soluble resin of the component (A) from the viewpoint of favorable sensitivity.

### (C) Thermal crosslinking agent

The thermal crosslinking agent of the component (C) contains one or more compounds that crosslink the alkali-soluble resin by heat. The compound constituting the thermal crosslinking agent may have a plurality of functional groups that can be bonded to the molecular chain of the alkali-soluble resin by a reaction with the alkali-soluble resin. Examples of the functional groups include an alkoxy group, an epoxy group, and an oxazoline group. The thermal crosslinking agent may contain an alkoxy compound having a plurality of alkoxy groups.

It is considered that an alkoxy compound that can be used as a thermal crosslinking agent mainly functions as a thermal crosslinking agent for bridging the molecular chain of the alkali-soluble resin by the reaction of an alkoxy group with an aromatic group (phenylene group) to which a phenolic hydroxyl group is bonded. The number of the alkoxy groups in the alkoxy compound may be 2 or more, 3 or more, or 4 or more or 20 or less, 15 or less, or 10 or less.

At least some of the two or more alkoxy groups of the alkoxy compound may be methoxy groups. In other words, the alkoxy compound may have a plurality of methoxy groups. The alkoxy compound may have four or more methoxy groups.

The alkoxy compound may have a cyclic group obtained by removing one or more hydrogen atoms from benzene, 1,3,5-triazine, or glycoluril, 2-imidazolidinone, or urea, and an alkoxyalkyl group (for example, a methoxymethyl group or a 1,3-dimethoxypropan-2-yl group) may be bonded to the cyclic group. The alkoxy compound having a cyclic group (benzene ring) obtained by removing a hydrogen atom from benzene may have a phenolic hydroxyl group bonded to the cyclic group. In the present disclosure, a compound having an alkoxy group and a phenolic hydroxyl group can be regarded as a thermal crosslinking agent of the component (C) rather than the alkali-soluble resin. The alkoxy compound having an alkoxy group and a phenolic hydroxyl group can contribute to the improvement in sensitivity of the photosensitive resin composition.

The weight average molecular weight of the alkoxy compound may be 3000 or less, 2000 or less, or 1500 or less or 100 or more from the viewpoint of the balance among the solubility in an alkali developing solution, photosensitive properties, and mechanical strength.

Specific examples of the alkoxy compound having a phenolic hydroxyl group include a compound represented by the following Formula (41), (42), (43), (44), (45), or (46). Specific examples of the alkoxy compound having a cyclic group obtained by removing one or more hydrogen atoms from 1,3,5-triazine, glycoluril, 2-imidazolidinone, or urea include a compound represented by the following Formula (47), (48), (49), or (50).

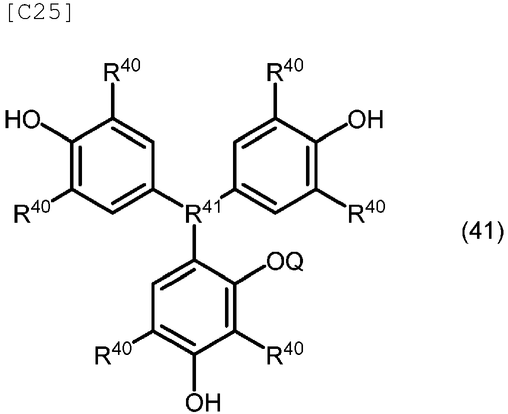

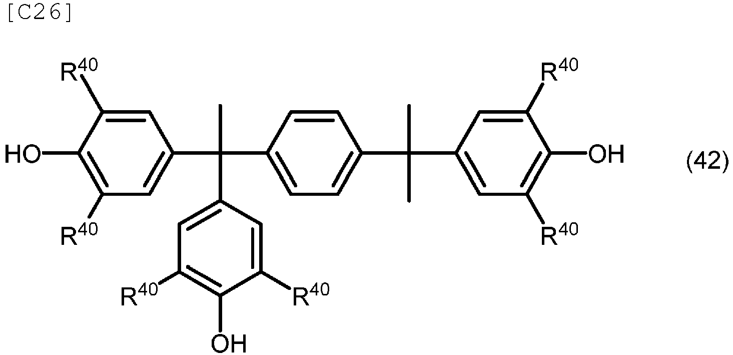

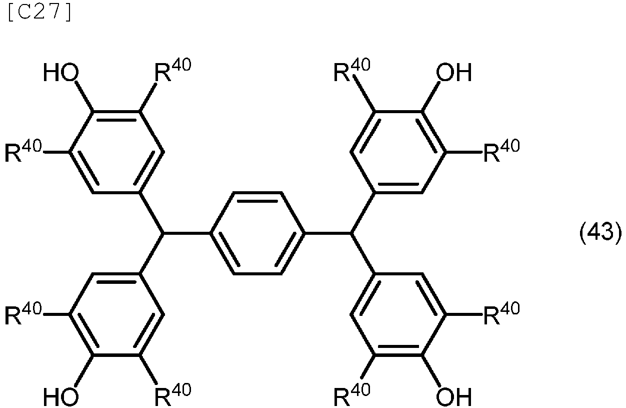

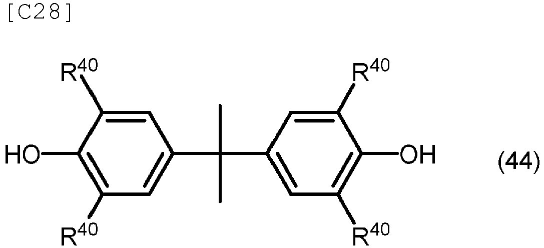

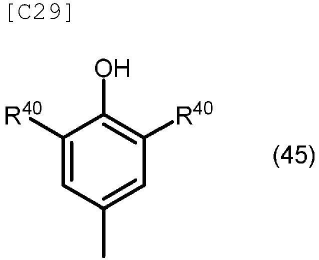

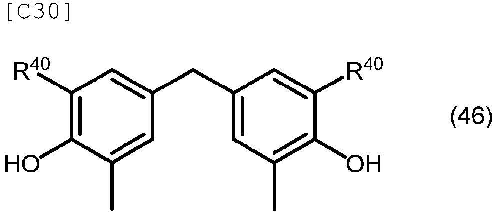

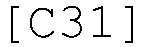

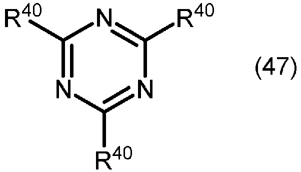

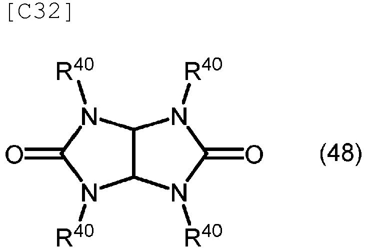

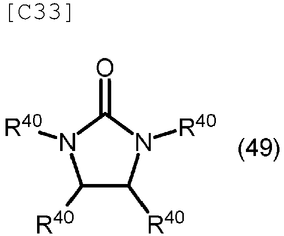

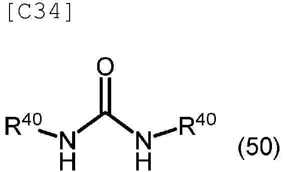

In Formulas (41) to (50), R⁴⁰ represents an alkoxyalkyl group, and a plurality of R⁴⁰'s in the same molecule may be the same or different. R⁴⁰ may be a methoxyalkyl group or a dimethoxyalkyl group, examples of which include a methoxymethyl group (-CH₂OCH₃) and a 1,3-dimethoxypropan-2-yl group represented by the following formula.

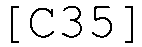

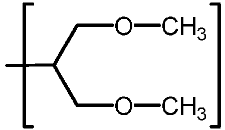

The content of the thermal crosslinking agent (or alkoxy compound) may be 1% to 70% by mass, 2% to 50% by mass, or 3% to 40% by mass with respect to the content of the alkali-soluble resin of the component (A) from the viewpoint of the heat resistance and warping suppression of the insulating resin film (cured film).

In the photosensitive resin composition, the total content of (A) the alkali-soluble resin, (B) the photoacid generator, and (C) the thermal crosslinking agent may be 50% by mass or more, 60% by mass or more, 70% by mass or more, 80% by mass or more, 90% by mass or more, or 95% by mass or more or 100% by mass or less based on the amount of the photosensitive resin composition. In a case where the photosensitive resin composition contains a solvent, the amount of the photosensitive resin composition here an amount that excludes the amount the solvent.

### Other components

The photosensitive resin composition may further contain, in addition to the components (A) to (C), other components such as an elastomer, an auxiliary adhesive, a solvent, a compound that generates an acid upon heating, a dissolution promoter, a dissolution inhibitor, a Cu rust inhibitor, a coupling agent, a surfactant and a leveling agent. In addition to the component (A), the photosensitive resin composition may further contain an alkali-soluble resin that does not fall under the category of the component (A).

The elastomer may be, for example, one or more selected from a styrene-based elastomer, an olefin-based elastomer, a urethane-based elastomer, a polyester-based elastomer, a polyamide-based elastomer, an acrylic elastomers, or a silicone-based elastomer.

The elastomer may be an acrylic elastomer containing a (meth)acrylic acid alkyl ester as a monomer unit. The (meth)acrylic acid alkyl ester may have an alkyl group having 1 to 20 carbon atoms. The acrylic elastomer may further contain, as a monomer unit, one or more acrylic monomers selected from an ester of (meth)acrylic acid with an aliphatic alcohol having an amino group, a (meth)acrylic acid alkyl ester having a hydroxyalkyl group having 4 to 20 carbon atoms, or (meth)acrylic acid. The content of the elastomer may be 0% to 50% by mass, 0.5% to 50% by mass, 1% to 30% by mass, or 2% to 20% by mass with respect to the amount of the alkali-soluble resin. "(Meth)acrylic acid" means acrylic acid or methacrylic acid.

The auxiliary adhesive may contain a nitrogen-containing aromatic compound, examples of which include 1H-tetrazole, 5-aminotetrazole, 5-phenyltetrazole, and 5-methyltetrazole. The content of the auxiliary adhesive may be 0% to 20% by mass, 0.01% to 20% by mass, 0.015% to 10% by mass, or 0.02% to 7% by mass with respect to the content of the alkali-soluble resin of the component (A).

Examples of the solvent include γ-butyrolactone, ethyl lactate, propylene glycol monomethyl ether acetate, benzyl acetate, n-butyl acetate, ethoxyethyl propionate, 3-methylmethoxypropionate, N-methyl-2-pyrrolidone, N,N-dimethylformamide, N,N-dimethylacetamide, dimethyl sulfoxide, hexamethylphosphorylamide, tetramethylene sulfone, diethyl ketone, diisobutyl ketone, methyl amyl ketone, cyclohexanone, propylene glycol monomethyl ether, propylene glycol monopropyl ether, propylene glycol monobutyl ether, and dipropylene glycol monomethyl ether. These solvents can be used singly or in combination of two or more kinds thereof. The solvent may include ethyl lactate, γ-butyrolactone, or a combination thereof. In the photosensitive resin composition containing a solvent, the concentration of components (solid components) other than the solvent may be 1% to 80% by mass based on the mass of the photosensitive resin composition containing a solvent.

The compound that generates an acid upon heating promotes the thermal crosslinking reaction of the alkali-soluble resin with the oxazoline compound or alkoxy compound, and as a result, the heat resistance of the cured film can be further improved. The compound that generates an acid upon heating can also contribute to the improvement in resolution. Examples of the compound that generates an acid upon heating include salts formed from strong acids and bases, such as onium salts, and imido sulfonates. The content of the compound that generates an acid upon heating may be 0% to 30% by mass, 0.1% to 30% by mass, 0.2% to 20% by mass, or 0.5% to 10% by mass with respect to the content of the alkali-soluble resin of the component (A).

The dissolution promoter is a component which increases the dissolution rate of the exposed portion into a developing solution, and may contribute to the improvement in sensitivity and resolution. The dissolution promoter may contain a compound having a carboxy group, a sulfo group, or a sulfonamide group. The content of the dissolution promoter may be 0% to 30% by mass or 0.01% to 30% by mass with respect to the content of the alkali-soluble resin of the component (A).

The dissolution inhibitor is a compound that inhibits dissolution of the exposed portion into an aqueous alkali solution, and is used to control the film thickness after development, the development time, and the contrast. Examples of the dissolution inhibitor include diphenyliodonium nitrate, bis(p-tert-butylphenyl)iodonium nitrate, diphenyliodonium bromide, diphenyliodonium chloride, and diphenyliodonium iodide. The content of the dissolution inhibitor may be 0% to 20% by mass, 0.01% to 20% by mass, 0.01% to 15% by mass, or 0.05% to 10% by mass with respect to the content of the alkali-soluble resin of the component (A).

The coupling agent may contain an organosilane compound (silane coupling agent), an aluminum chelating compound, or a combination thereof. Examples of commercially available organosilane compounds include KBM-403, KBM-803, and KBM-903 (product names, manufactured by Shin-Etsu Chemical Co., Ltd.). The content of the coupling agent may be 0% to 20% by mass, 0.1% to 20% by mass, or 0.5% to 10% by mass with respect to the content of the alkali-soluble resin of the component (A).

Examples of the surfactant or leveling agent include polyoxyethylene lauryl ether, polyoxyethylene stearyl ether, polyoxyethylene oleyl ether, and polyoxyethylene octylphenol ether. Examples of commercially available products include Megaface F-171, F-565, and RS-78 (product names, manufactured by DIC Corporation). The content of the surfactant or leveling agent may be 0% to 5% by mass, 0.001% to 5% by mass, or 0.01% to 3% by mass with respect to the content of the alkali-soluble resin of the component (A).

### Method for forming insulating resin film having pattern

It is possible to form an insulating resin film having a pattern that includes an aperture by photolithography using the photosensitive resin composition according to the present disclosure. Fig. 1 is a flowchart illustrating an example of the method for forming an insulating resin film having a pattern that includes an aperture. The method illustrated in Fig. 1 includes: step S1 of forming a photosensitive layer that contains the photosensitive resin composition; step S2 of exposing a part of the photosensitive layer to light; step S3 of forming an insulating resin film having a pattern that includes an aperture by development for removing a part of the photosensitive layer; and step S4 of heating the insulating resin film.

The photosensitive layer that contains the photosensitive resin composition is formed, for example, on any substrate, such as a glass substrate, a semiconductor substrate, a metal oxide insulator substrate (for example, TiO₂ or SiO₂), or a silicon nitride substrate. The photosensitive layer is formed by a method including, for example, applying the positive-type photosensitive resin composition containing a solvent onto the substrate, and removing the solvent from the coating film. The coating film may be heated to remove the solvent. The thickness of the photosensitive layer may be 0.1 to 40 µm.

A part of the photosensitive layer is exposed by irradiation with active rays through a mask. The active rays may be ultraviolet light, visible light, or radioactive rays or may be g-line, h-line, i-line, or a combination thereof.

By development for removing a part of the photosensitive layer, a resin film (insulating resin film) having a pattern that includes an aperture is formed. A developing solution may be used for the development. Examples of development in which a developing solution is used include shower development, spray development, immersion development, and paddle development. The resin film (insulating resin film) after development may be washed with water or the like.

The developing solution may be an aqueous alkali solution. The aqueous alkali solution may contain one or more bases selected from sodium carbonate, sodium hydroxide, potassium hydroxide, sodium silicate, ammonia, ethylamine, diethylamine, triethylamine, triethanolamine, or tetramethylammonium hydroxide (TMAH). The concentration of the base in the aqueous alkali solution may be 0.1% to 10% by mass based on the mass of the aqueous alkali solution. The developing solution may contain an alcohol or a surfactant.

By heating the resin film (insulating resin film) that is the photosensitive layer left after development, the insulating resin film, which is a resin film containing a thermal curing product of the photosensitive resin composition, is formed mainly by the reaction of the alkali-soluble resin with the thermal crosslinking agent. The heating temperature may be 300°C or less, 270°C or less, or 250°C or less or 160°C or more. The heating time may be, for example, 0.5 hours or more and 5 hours or less.

The resin film (insulating resin film) can be heated, for example, using a heating device such as a quartz tube furnace, a hot plate, a rapid thermal annealing, a vertical diffusion furnace, an infrared curing furnace, an electron beam curing furnace, a microwave curing furnace, a microwave curing device or a frequency-variable microwave curing device. The heating atmosphere may be, for example, an air atmosphere or an inert gas atmosphere containing nitrogen or the like.

### Semiconductor device

The insulating resin film can be, for example, an insulating layer constituting the wiring portion of a semiconductor device. The semiconductor device may include a semiconductor chip, a conductor wiring layer connected to the semiconductor chip, and a wiring portion (rewiring portion) including one or more insulating layers, and at least some of one or more wiring layers may be an insulating resin film containing a cured product of the photosensitive resin composition according to the present disclosure.

Fig. 2 is a partial cross-sectional view illustrating an example of a semiconductor device having an insulating layer. A semiconductor device 100 illustrated in Fig. 2 includes a semiconductor chip 10 and a wiring portion 20 provided on the semiconductor chip 10. The wiring portion 20 includes a conductor wiring layer 31 connected to the semiconductor chip 10, a surface protective layer 41, a cover coat layer 42, and a conductive ball 50. The semiconductor device 100 may be a semiconductor package having the configuration of a wafer level package (WLP). The surface protective layer 41 and the cover coat layer 42 are laminated in this order from the semiconductor chip 10 side, and the conductive ball 50 is provided on the outer side of the cover coat layer 42. The surface protective layer 41 and the cover coat layer 42 are insulating layers, and one or both of these may be an insulating resin film containing a cured product of the photosensitive resin composition according to the present disclosure.

The semiconductor chip 10 includes a chip body portion 11 having a circuit surface, a pad portion 12 provided on the circuit surface of the chip body portion 11, and a protective film 13 having a pattern that includes an aperture through which the pad portion 12 is exposed. The conductor wiring layer 31 of the wiring portion 20 is a rewiring layer connected to the pad portion 12 and extends to the inner part of the conductive ball 50 between the surface protective layer 41 and the cover coat layer 42. A connection portion 32 to be connected to the conductive ball 50 is provided on an end portion of the conductor wiring layer 31. A barrier metal 33 is provided between the connection portion 32 and the conductive ball 50. The pad portion 12, conductor wiring layer 31, connection portion 32, barrier metal 33 and conductive ball 50 are electrically connected in this order.

The wiring portion (rewiring portion) of the semiconductor device may have a plurality of conductor wiring layers, and an insulating resin film containing a cured product of the photosensitive resin composition according to the present disclosure may be provided as an interlayer insulating layer provided between adjacent conductor wiring layers. In the semiconductor device, the interlayer insulating layer, the surface protective layer, or both of these may be an insulating resin film containing a cured product of the photosensitive resin composition according to the present disclosure.

The semiconductor device may be a memory. Examples of electronic devices including the semiconductor device according to the present disclosure include a mobile phone, a smartphone, a tablet terminal, a personal computer, and a hard disk suspension.

### Examples

The present invention is not limited to the following Examples.

### 1. Raw materials

The following raw materials were prepared.
(A) Alkali-soluble resin
   A1-1: Novolac resin having phenolic hydroxyl group and imide group (acid-catalyzed reaction product of bis(2-hydroxy-5-methylphenyl)-4,4'-oxyphthalimide (compound represented by Formula (I-1)) with 1,4-bismethoxymethylbenzene, weight average molecular weight: 30000) 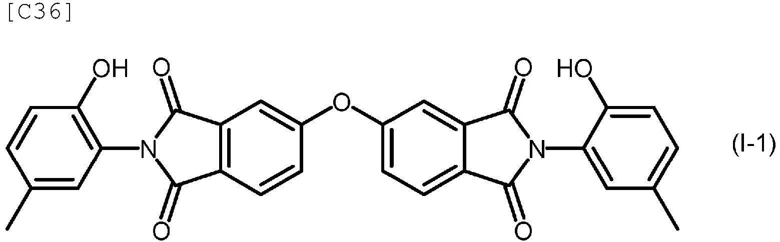
   A1-2: Novolac resin having phenolic hydroxyl group and imide group (acid-catalyzed reaction product of bis(2-hydroxyphenyl)-4,4'-oxyphthalimide (compound represented by Formula (II-1)) with 1,4-bismethoxymethylbenzene, weight average molecular weight: 36000) 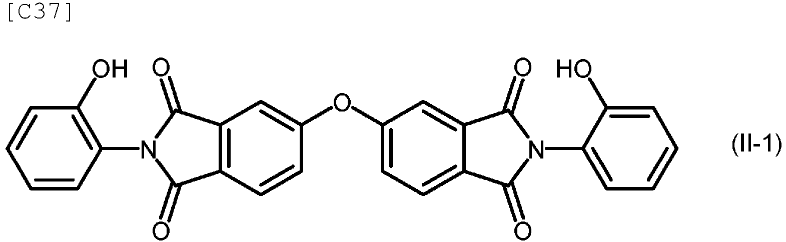
   A1-3: Novolac resin having phenolic hydroxyl group and imide group (acid-catalyzed reaction product of bis(3-hydroxyphenyl)-4,4'-oxyphthalimide (compound represented by Formula (II-2)) with 1,4-bismethoxymethylbenzene, weight average molecular weight: 72000) 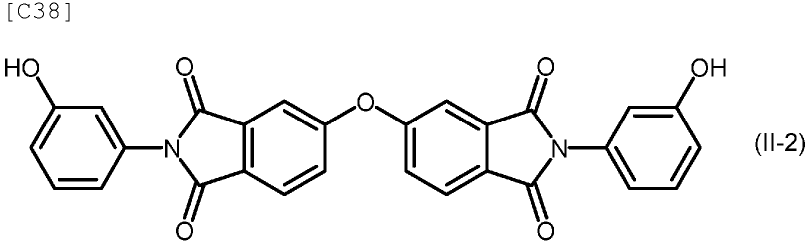
   A2-1: Novolac resin having phenolic hydroxyl group and imide group (acid-catalyzed reaction product of N,N'-bis(2-hydroxy-5-methylphenyl)-4,4'-biphthalimide (compound represented by Formula (I-2)) with 1,4-bismethoxymethylbenzene, weight average molecular weight: 13000) 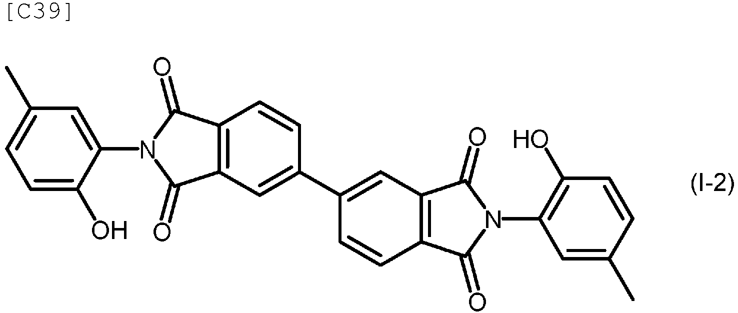
   A2-2: Novolac resin having phenolic hydroxyl group and imide group (acid-catalyzed reaction product of N,N'-bis(3-hydroxyphenyl)-4,4'-biphthalimide (compound represented by Formula (II-3)) with 1,4-bismethoxymethylbenzene, weight average molecular weight: 78000) 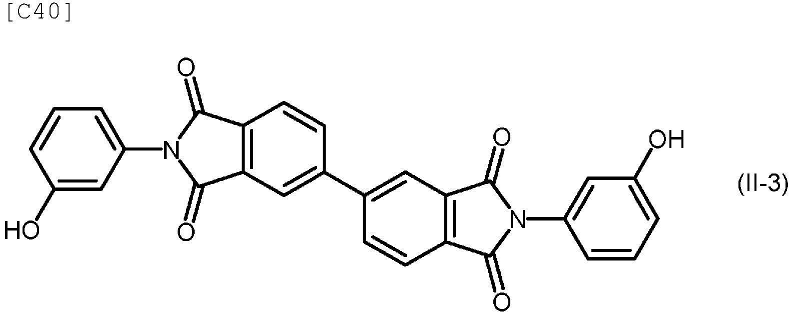
(B) Photoacid generator
   B1: 1-Naphthoquinone-2-diazide-5-sulfonic acid ester of 1,1-bis(4-hydroxyphenyl)-1-[4-{1-(4-hydroxyphenyl)-1-methylethyl}phenyl]ethane (esterification rate of about 90%, manufactured by DAITO CHEMIX Corporation, product name "PA28")
(C) Thermal crosslinking agent
   C1: 4,4'-[1-[4-[1-[4-Hydroxy-3,5-bis(methoxymethyl)phenyl]-1-methylethyl]phenyl]ethylidene]bis[2,6-bis(methoxymethyl)phenol] (compound represented by Formula (42), where R⁴⁰ is a methoxymethyl group, manufactured by Honshu Chemical Industry Co., Ltd., product name "HMOM-TPPA")
(D) Auxiliary adhesive
   D1: 5-Aminotetrazole (manufactured by Toyobo Co., Ltd., product name "HAT")
(E) Silane coupling agent
   E1: 3-Glycidyloxypropyltrimethoxysilane (manufactured by Shin-Etsu Chemical Co., Ltd., product name "KBM403")

### 2. Photosensitive resin composition

The respective components were mixed with ethyl lactate and γ-butyrolactone so as to have the blending ratio (parts by mass) presented in Table 1 or 2. The mixture was filtered under pressure through a polytetrafluoroethylene filter with 0.2 µm pores, thereby preparing a photosensitive resin composition.

### 3. Evaluation

### 3-1. Elongation at break and breaking strength of insulating resin film (cured film)

A photosensitive resin composition was applied onto a silicon substrate by spin coating. The coating film was heated at 120°C for 3 minutes to remove the solvent, thereby forming a photosensitive layer having a film thickness of 8 to 9 µm. Next, the photosensitive layer was exposed to light of all wavelengths through a mask using an aligner (manufactured by SUSS MicroTec SE, product name "MA-8"). The exposure dose was 1500 mJ/cm². After exposure, by development using a 2.38% TMAH aqueous solution, an insulating resin film having a pattern that included a linear portion having a width of 10 mm was formed. The formed insulating resin film was heated using an inert gas oven (INH-9CD-S) in a nitrogen atmosphere under a condition in which the temperature was raised to 230°C over 1 hour and maintained at 230°C for 2 hours to carry out curing of the insulating resin film. The film thickness of the cured film, which was the insulating resin film after heating, was about 7 µm.

A rectangular test piece having a width of 10 mm was prepared from the cured film peeled off from the silicon substrate. Tensile testing of the test piece was performed using Autograph AGS-100NX manufactured by Shimadzu Corporation. In tensile testing, the distance between chucks was 20 mm, the tension speed was 5 mm/min, and the temperature of the measurement environment was room temperature (20°C to 25°C). From the results of tensile testing, the average of the measured values for six test pieces obtained from the cured films prepared under the same conditions were recorded as the elongation at break and breaking strength.

### 3-2. Tack after development

The presence or absence of tack on the insulating resin film formed in "3-1. Elongation at break and breaking strength of insulating resin film (cured film)" was examined by the sense of touch immediately after development and in about 30 minutes after development. The degree of tack on the surface of the insulating resin film after development was judged according to the following criteria.
A: No tack immediately after development
B: Tack immediately after development but no tack after lapse of time
C: Tack immediately after development and after lapse of time

**[Table 1]**

| | | Hydroxyphenyl group | Example | Comparative Example | Comparative Example |
|---|---|---|---|---|---|
| | | | 1-1 | 1-1 | 1-2 |
| (A) | A1-1 | 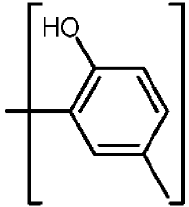 | 100 | - | - |
| | A1-2 | 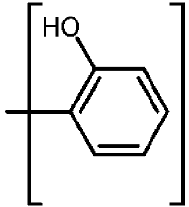 | - | 100 | - |
| | A1-3 | 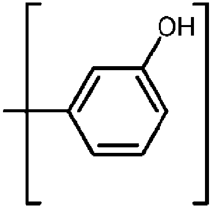 | - | - | 100 |
| (B) | B1 | | 12 | 12 | 12 |
| (C) | C1 | | 25 | 25 | 25 |
| (D) | D1 | | 2 | 2 | 2 |
| (E) | E1 | | 1 | 1 | 1 |
| Elongation at break [%] | | | 67 | 52 | 50 |
| Breaking strength [MPa] | | | 172 | 159 | 150 |
| Tack after development | | | A | B | c |

**[Table 2]**

| | | Hydroxyphenyl group | Example | Comparative Example |
|---|---|---|---|---|
| | | | 2 | 2 |
| (A) | A2-1 | 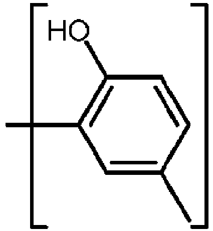 | 100 | - |
| | A2-2 | 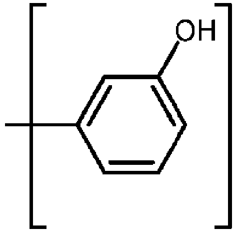 | - | 100 |
| (B) | B1 | | 12 | 12 |
| (C) | C1 | | 25 | 25 |
| (D) | D1 | | 2 | 2 |
| (E) | E1 | | 1 | 1 |
| Elongation at break [%] | | | 63 | 47 |
| Breaking strength [MPa] | | | 140 | 129 |
| Tack after development | | | A | C |

Tables 1 and 2 present the structures of hydroxyphenyl groups of bisphenol imide compounds constituting the alkali-soluble resins as well as the evaluation results. As presented in Tables 1 and 2, it has been confirmed that the photosensitive resin compositions of Examples can afford an insulating resin film, which exhibits a large elongation at break and a large breaking strength and a surface exhibiting little tack immediately after development.

### Reference Signs List

- 10: Semiconductor chip
- 11: Chip body portion
- 12: Pad portion
- 13: Protective film
- 20: Wiring portion
- 31: Conductor wiring layer
- 32: Connection portion
- 33: Barrier metal
- 41: Surface protective layer (insulating resin film)
- 42: Cover coat layer (insulating resin film)
- 50: Conductive ball
- 100: Semiconductor device

## Claims

1. A positive-type photosensitive resin composition comprising:
(A) an alkali-soluble resin;
(B) a photoacid generator that is a compound generating an acid by light; and
(C) a thermal crosslinking agent that is a compound crosslinking the alkali-soluble resin by heat, wherein
the alkali-soluble resin contains a constitutional unit that is a group obtained by removing one or more hydrogen atoms from a bisphenol imide compound represented by the following Formula (I): 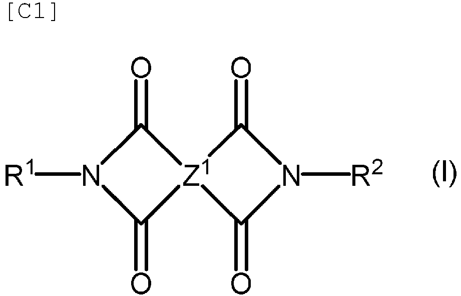
wherein Z¹ is a tetravalent organic group, R¹ and R² are each independently a hydroxyphenyl group represented by the following Formula (1a) or (1b): 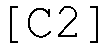 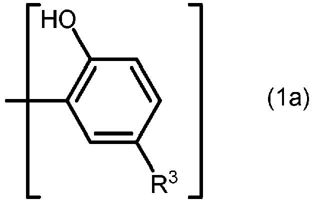 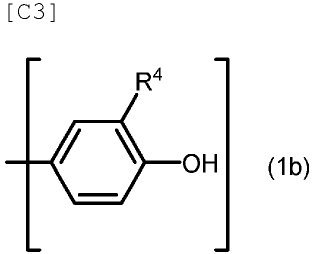
wherein R³ and R⁴ are each independently an alkyl group having 1 to 3 carbon atoms.

2. The positive-type photosensitive resin composition according to claim 1, wherein the bisphenol imide compound is a compound represented by the following Formula (I'): 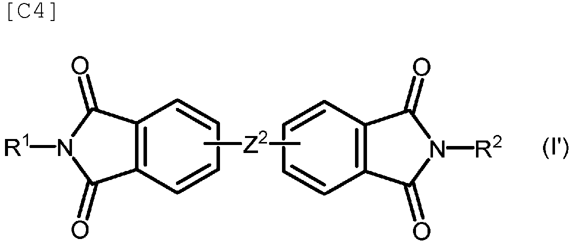 wherein R¹ and R² are synonymous with R¹ and R² in Formula (I), and Z² is a divalent organic group or a covalent bond.

3. The positive-type photosensitive resin composition according to claim 1, wherein the alkali-soluble resin includes a novolac resin that is a product of a reaction of phenol compounds including the bisphenol imide compound with one or more reactive compounds selected from an aldehyde compound, a compound having a plurality of methoxymethyl groups, or a compound having a plurality of hydroxymethyl groups.

4. The positive-type photosensitive resin composition according to claim 3, wherein a proportion of the bisphenol imide compound is 10 mol% or more and 100 mol% or less based on a total amount of the phenol compounds.

5. The positive-type photosensitive resin composition according to claim 1, wherein the thermal crosslinking agent contains an alkoxy compound having a plurality of alkoxy groups.

6. A method for forming an insulating resin film, the method comprising:
exposing a part of a photosensitive layer containing the positive-type photosensitive resin composition according to any one of claims 1 to 5;
forming an insulating resin film having a pattern that includes an aperture by development for removing a part of the photosensitive layer; and
heating the insulating resin film.

7. An insulating resin film comprising a cured product of the positive-type photosensitive resin composition according to any one of claims 1 to 5 and having a pattern that includes an aperture.

8. A semiconductor device comprising:
a semiconductor chip; and
a wiring portion that includes a conductor wiring layer connected to the semiconductor chip and one or more insulating layers,
wherein at least some of the one or more insulating layers are the insulating resin film according to claim 7.
